# EUROPEAN PATENT APPLICATION

(11) **EP 1 403 791 A2**
(43) Date of publication of application: **31.03.2004**
(21) Application number: 03077827.8
(22) Date of filing: 09.09.2003
(51) Int. Cl.: G06F 17/50

(54) **Routing of interconnected regions**

(30) Priority: 27.09.2002 GB 0222528
(71) Applicant: Zuken Limited, Almondsbury, Bristol BS32 4RF (GB)
(72) Inventor: Greene, Michael Thomas, Redland Bristol BS6 6EL (GB)
(74) Representative: Newstead, Michael John

(57) **Abstract**

A method is disclosed of determining the routing of interconnected regions of a routing problem by considering all required connections in parallel and only attempting to resolve conflicts when at least some relevant contextual information has been assembled.

## Description

The present invention relates to the routing of interconnected regions, such as the tracks of electrical circuits within integrated circuits, multi-chip modules, circuit boards or systems.

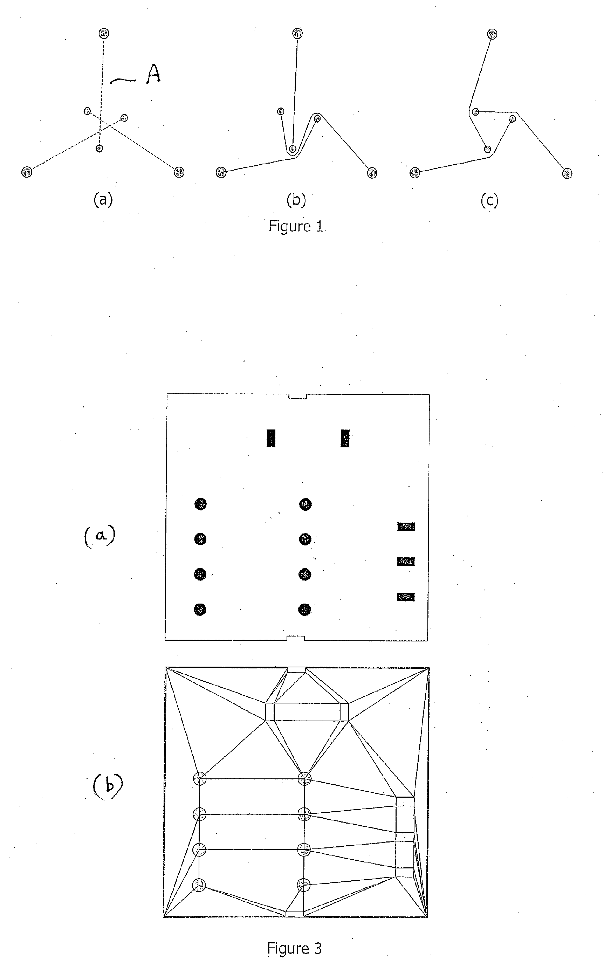

Various computer programs (so-called "routers") are known for the routing of tracks of electrical circuits. These are so-called "serial" routers. In such routing, a "connection" indicates which regions of the circuit must be connected together. A serial router considers each requested connection separately and realises it into conductive track segments before moving on to the next connection. There are many cases where a standard serial router will never find the routing solution that an experienced human router might find. Consider the connections in Figure 1(a). A serial router will always route one of these first, and will then route the others round it. If the router starts with connection A, it may produce a solution rather like Figure 1(b). It can never find the optimal solution, shown in Figure 1(c), unless by some non-serial part of its algorithm, e.g. a post-processing tool. An experienced human router would instantly find the solution of Figure 1(c) by seeing the problem as a whole.

Serial routers also suffer from problems of lack of symmetry. A router is said to be "symmetric" if and only if the results it produces are independent of the order in which the connections are considered. This order typically depends on the order they were read in from a file or are stored in memory, or some other order irrelevant to the problem. Consequently, two regions of a routing problem which look the same on input can be solved in completely different ways.

Standard serial routers use combinations of various techniques to make themselves appear more non-serial (or "concurrent") and symmetric. On certain types of design they can show some success at this. Several passes with "rip-up-and-reroute", together with evolving costs for doing so, can equilibrate the relative importance of connections very well, and "push-aside" and other tools can also improve the symmetry.

Most routers available today put down routes while performing their processing as actual geometric objects. These obj ects can be pushed, or even ripped up and rerouted, by subsequent steps in the algorithm, but they still have a physical presence. Managing this geometrical data costs time and memory. Furthermore, how some connections are decided can make subsequent completion of other connections impossible however they are realised. There are many cases in which it is only by taking two or more connections into account simultaneously that a solution can be found.

According to the present invention, there is provided a method of determining the routing of interconnected regions of a routing problem by considering all required connections in parallel and only attempting to resolve conflicts when at least some relevant contextual information has been assembled.

The method could be such that resolving of conflicts is only attempted when all possible relevant contextual information has been assembled.

A method according to the invention could comprise:-
(a) defining, for each set of regions to be connected, routing which represents a suitable manner of connecting them, respecting only those conflicts which have been explicitly registered with the set currently being considered;
(b) collating all such proposed routing and resolving any conflicts in a symmetric manner;
(c) registering such conflicts with the sets of regions which will be required to respect them on the next pass;
(d) repeating steps (a) to (c) until a sufficient completion and quality of routing solution is attained; and
(e) converting the routing into suitable geometric representations of routing paths in a way which takes all desired routing into account symmetrically and simultaneously.

The example of a method according to the invention to be described is "concurrent" in the following sense. An algorithm running on a typical computer today is never truly concurrent, because at any time the processor is dealing with one particular aspect of the design, but the method to be described delays all important routing and conflict resolution decisions until all possible relevant contextual information has been assembled. This means that the routing itself is concurrent, and the strategy is similar to that which an experienced human router would go through. This leads to intuitive and elegant routing, because each path has been produced sympathetic to the requirements of all the other paths. The method is able to find the type of solution that an experienced user might come to, by considering the connections concurrently. The method to be described is new because the routing algorithm itself is concurrent and, consequently, symmetric.

The present invention will now be described with reference to the accompanying drawings, in which:-
Figure 1(a) shows a typical routing problem and 1(b) shows a solution which a standard serial router may generate, Figure 1(c) showing the ideal solution;
Figure 2 shows steps in a routing method according to an example of the invention;
Figures 3(a) and 3(b) show an example of a board and polygonalisation of it; and
Figures 4 - 8 show route layouts in an example of a method according to the invention.

The method to be described according to the invention is a router which avoids the above described problems by dealing only with the "topology" of a route. This is the route up to "homotopy" (continuous distortion with a small neighbourhood). At any point during the routing process, it is known with a certain "probability", or relative desirability, which obstructions the routes are currently thought to pass between, approximately where vias or other generated obstructions will be, etc., but not in detail exactly where route segments will start and end. This means that pushing and rip-up-and-reroute are both unnecessary, and gives the router a huge speed advantage for the expensive routing step. Furthermore, track realisation becomes a concurrent final step, and solutions which require more than one connection to be realised at the same time (and which are therefore impossible for a serial router to find) are readily accessible.

The method to be described is novel and powerful from the concurrent routing of its connections and from the concurrent realisation of these topological paths into actual routing. It is also unique in its ability to calculate the relative cost, or "probability", of routing taking a different (topological) path. The idea of the entire routing problem as the probabilistic superposition of many different topological routes is unique to the method.

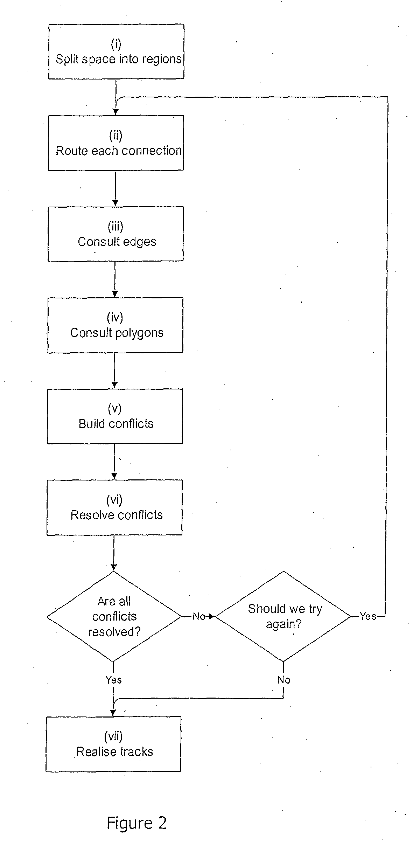

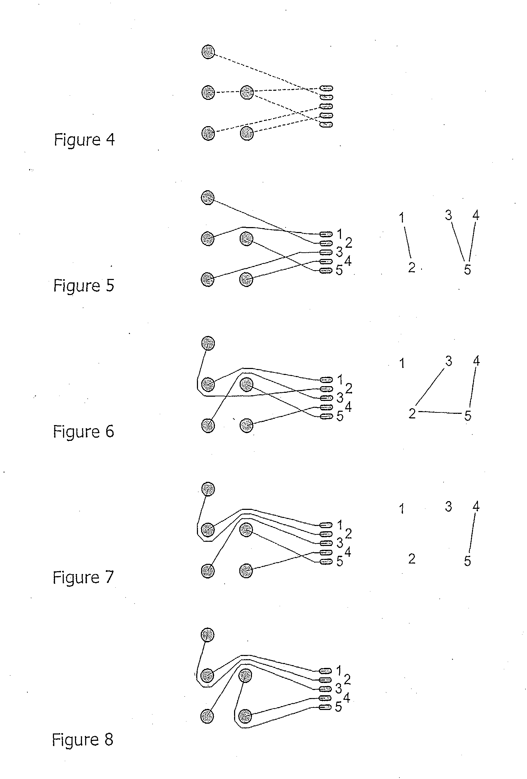

There will now be described with reference to Figure 2 an algorithm of the example.
(i) Split space into regions. This algorithm already existed in an equispace routing tool of Zuken Limited, 1500 Aztec West, Almondsbury, Bristol BS32 4RF, UK and is a sophisticated extension of the Delaunay triangulation algorithm. In Zuken's implementation, the regions are polygons and the shared boundaries are edges. Figure 3 shows an example board and the resulting polygonalisation.
(ii) Route each connection. This step is a fine-tuned flood search algorithm, stepping from one polygon to the next, attempting to find a permissible route for each connection considered in isolation.
(iii) Consult shared boundaries. Part of the concurrency comes from each boundary's ability to examine all connections across it and 'discourage' the least promising (by making them less probable, or more expensive) if there are too many. A shared boundary also decides the crossing order for its connections.
(iv) Consult regions. Regions are also consulted, allowing them to place putative vias, veto crossing tracks, and so on. They also help assemble conflict objects.
(v) Build conflicts. Since connections are routed independently, respecting only conflicts they have been explicitly told to respect, there is likely to be crossing routing. A conflict object holds information about a region of the board and the paths which cross there, and these are built with help from regions, shared boundaries, and the connections themselves.
(vi) Resolve conflicts. These conflicts are then resolved independently as far as possible. Often they cannot be resolved fully, so they are partially resolved ready for the next pass which builds lighter conflicts (which are generally easier to deal with).
(vii) Realise tracks. Once the homotopy classes of all connections are known, they can be converted to real conducting tracks and vias by existing Zuken tools. If the conflict resolution loop has been executed more than a fixed number of times, or if passes round this loop are no longer adding to the routing, as many tracks as possible are realised, and the algorithm ends.

The following is an example of a routing problem as solved by the method. For simplicity, the example consists of a small region of a single-layer design with only "2-base" (i.e. source-to-target) connections. The input is as in Figure 4, required connections being indicated by dotted lines.

First, each connection is given a chance to route itself ignoring all other connections. Their initial preferences are shown in Figure 5. Note that no actual track has been put down, the lines in this figure representing only the combinatorial or topological routes the connections currently prefer.

From this representation, the regions and region boundaries help construct an "intersection graph". This graph has a vertex for each connection and an edge between two vertices if the currently preferred routes of the associated connections cross. So the vertices are routing paths and the edges are conflicts. In Figure 5, the intersection graph has two components. The method considers them separately. Connections 1 and 2 cross, and it is better to reroute 2 to avoid 1 than it is to reroute 1 to avoid 2. Similarly, 5 meets both 3 and 4, and the best rerouting is that of 3 around 5.

The results of this rerouting are shown in Figure 6. Note that connection 2 has been diverted to clash with both 3 and 5, whereas it avoided them before. Note also that connection 1 appears to have been pushed upwards by connection 3, but since the routing is only stored topologically, no change to the data representing connection 1 is required.

A new intersection graph is now created. This has just one non-trivial component. The 'best' resolution of this component is to reroute connection 2 to avoid connections 3 and 5. The result of this rerouting is shown in Figure 7. Note again that connections 1 and 2 appear to have been pushed out of the way to allow space for 3, but since the routing paths are only stored topologically no change in data is required.

The resulting intersection graph has just one edge, and the best resolution of the corresponding conflict is to reroute connection 5 around connection 4.

This completes the topological part of the algorithm. The topological routing paths are realised concurrently into actual track objects to produce routing like that shown in Figure 8.

Since the method involves many separate entities considered concurrently, it is particularly suited to parallel processors, either within the same computer or across a network.

## Claims

1. A method of determining the routing of interconnected regions of a routing problem by considering all required connections in parallel and only attempting to resolve conflicts when at least some relevant contextual information has been assembled.

2. A method according to claim 1, wherein resolving of conflicts is only attempted when all possible relevant contextual information has been assembled.

3. A method according to claim 1 or 2, comprising the steps of:-
(a) defining, for each set of regions to be connected, routing which represents a suitable manner of connecting them, respecting only those conflicts which have been explicitly registered with the set currently being considered;
(b) collating all such proposed routing and resolving any conflicts in a symmetric manner;
(c) registering such conflicts with the sets of regions which will be required to respect them on the next pass;
(d) repeating steps (a) to (c) until a sufficient completion and quality of routing solution is attained; and
(e) converting the routing into suitable geometric representations of routing paths in a way which takes all desired routing into account symmetrically and simultaneously.

4. A method according to claim 3, in which the regions are polygons and the shared boundaries are edges.

5. A method according to any preceding claim, wherein the interconnected regions are regions of an electrical circuit.

6. A method of determining the routing of interconnected regions substantially as herein described with reference to Figure 2 and the accompanying drawings.
